# EUROPEAN PATENT APPLICATION

(11) **EP 4 270 502 A1**
(43) Date of publication of application: **01.11.2023**
(21) Application number: 20966910.0
(22) Date of filing: 24.12.2020
(51) Int. Cl.: H01L 39/22, H01L 29/06

(54) **QUANTUM BIT CIRCUIT, QUANTUM BIT COMPUTER, AND QUANTUM BIT CIRCUIT MANUFACTURING METHOD**

(71) Applicant: FUJITSU LIMITED, Kawasaki-shi, Kanagawa 211-8588 (JP)
(72) Inventor: OHTOMO, Manabu, Kawasaki-shi, Kanagawa 211-8588 (JP); KAWAGUCHI, Kenichi, Kawasaki-shi, Kanagawa 211-8588 (JP)
(74) Representative: Haseltine Lake Kempner LLP
(86) International application number: PCT/JP2020/048426
(87) International publication number: WO 2022/137421

(57) **Abstract**

A quantum bit circuit includes a first Majorana carrier that includes a first edge and extends in a first direction and a second Majorana carrier that includes a second edge and extends in a second direction intersecting with the first direction, in which the first Majorana carrier includes a first region where a Majorana particle can exist, in a portion of the first edge overlapping the second edge in plan view, the second Majorana carrier includes a second region where a Majorana particle can exist, in a portion of the second edge overlapping the first edge in plan view, and the Majorana particle in the first region and the Majorana particle in the second region are exchangeable.

## Description

### FIELD

The present disclosure relates to a quantum bit circuit, a quantum computer, and a method for manufacturing the quantum bit circuit.

### BACKGROUND

A quantum computer using Majorana particles has been studied. As a structure for generating the Majorana particles, for example, the following two types of techniques have been proposed. One is a technique using a one-dimensional semiconductor nanowire, and another one is a technique using a two-dimensional topological insulator.

### SUMMARY

### TECHNICAL PROBLEM

Although proposals based on theories have been made, it is extremely difficult to manufacture a quantum bit circuit that can be easily controlled, with a high yield.

An object of the present disclosure is to provide a quantum bit circuit that can manufacture a structure that can be easily controlled, with a high yield, a quantum computer, and a method for manufacturing the quantum bit circuit.

### SOLUTION TO PROBLEM

According to one aspect of the present disclosure, a quantum bit circuit is provided that includes a first Majorana carrier that includes a first edge and extends in a first direction and a second Majorana carrier that includes a second edge and extends in a second direction intersecting with the first direction, in which the first Majorana carrier includes a first region where Majorana particles can exist, in a portion of the first edge overlapping the second edge in plan view, the second Majorana carrier includes a second region where Majorana particles can exist, in a portion of the second edge overlapping the first edge in plan view, and the Majorana particle in the first region and the Majorana particles in the second region are exchangeable.

### ADVANTAGEOUS EFFECTS OF INVENTION

According to the present disclosure, a structure that is easy to be controlled can be manufactured with a high yield.

### BRIEF DESCRIPTION OF DRAWINGS

FIG. 1 is a top view of a quantum bit circuit according to a first embodiment;
FIG. 2 is an enlarged view illustrating a part in FIG. 1;
FIG. 3 is a cross-sectional diagram (part 1) illustrating the quantum bit circuit according to the first embodiment;
FIG. 4 is a cross-sectional diagram (part 2) illustrating the quantum bit circuit according to the first embodiment;
FIG. 5 is a diagram illustrating an example of an operation of the quantum bit circuit according to the first embodiment;
FIG. 6 is a top view (part 1) illustrating a method for manufacturing the quantum bit circuit according to the first embodiment;
FIG. 7 is a top view (part 2) illustrating the method for manufacturing the quantum bit circuit according to the first embodiment;
FIG. 8 is a top view (part 3) illustrating the method for manufacturing the quantum bit circuit according to the first embodiment;
FIG. 9 is a top view (part 4) illustrating the method for manufacturing the quantum bit circuit according to the first embodiment;
FIG. 10 is a top view (part 5) illustrating the method for manufacturing the quantum bit circuit according to the first embodiment;
FIG. 11 is a top view (part 6) illustrating the method for manufacturing the quantum bit circuit according to the first embodiment;
FIG. 12 is a top view (part 7) illustrating the method for manufacturing the quantum bit circuit according to the first embodiment;
FIG. 13 is a top view (part 8) illustrating the method for manufacturing the quantum bit circuit according to the first embodiment;
FIG. 14 is a top view illustrating a quantum bit circuit according to a second embodiment;
FIG. 15 is an enlarged view illustrating a part in FIG. 14;
FIG. 16 is a cross-sectional diagram (part 1) illustrating the quantum bit circuit according to the second embodiment;
FIG. 17 is a cross-sectional diagram (part 2) illustrating the quantum bit circuit according to the second embodiment;
FIG. 18 is a band diagram illustrating an example of a valence band and a conduction band of a laminate;
FIG. 19 is a diagram illustrating a change in a tunnel barrier;
FIG. 20 is a diagram illustrating an example of an operation of the quantum bit circuit according to the second embodiment;
FIG. 21 is a diagram illustrating a method (part 1) for manufacturing the quantum bit circuit according to the second embodiment;
FIG. 22 is a diagram illustrating the method (part 2) for manufacturing the quantum bit circuit according to the second embodiment;
FIG. 23 is a diagram illustrating the method (part 3) for manufacturing the quantum bit circuit according to the second embodiment;
FIG. 24 is a diagram illustrating the method (part 4) for manufacturing the quantum bit circuit according to the second embodiment;
FIG. 25 is a diagram illustrating the method (part 5) for manufacturing the quantum bit circuit according to the second embodiment;
FIG. 26 is a diagram illustrating the method (part 6) for manufacturing the quantum bit circuit according to the second embodiment;
FIG. 27 is a diagram illustrating the method (part 7) for manufacturing the quantum bit circuit according to the second embodiment;
FIG. 28 is a diagram illustrating the method (part 8) for manufacturing the quantum bit circuit according to the second embodiment;
FIG. 29 is a diagram illustrating the method (part 9) for manufacturing the quantum bit circuit according to the second embodiment;
FIG. 30 is a partially transparent top view illustrating a quantum bit circuit according to a third embodiment;
FIG. 31 is a cross-sectional diagram (part 1) illustrating the quantum bit circuit according to the third embodiment;
FIG. 32 is a cross-sectional diagram (part 2) illustrating the quantum bit circuit according to the third embodiment;
FIG. 33 is a cross-sectional diagram (part 3) illustrating the quantum bit circuit according to the third embodiment;
FIG. 34 is a cross-sectional diagram (part 4) illustrating the quantum bit circuit according to the third embodiment; and
FIG. 35 is a diagram illustrating a quantum computer.

### DESCRIPTION OF EMBODIMENTS

Hereinafter, embodiments of the present disclosure will be specifically described with reference to the attached drawings. Note that, in the present specification and drawings, components having substantially the same functional configuration are denoted with the same reference numeral, and redundant descriptions may be omitted.

### (First Embodiment)

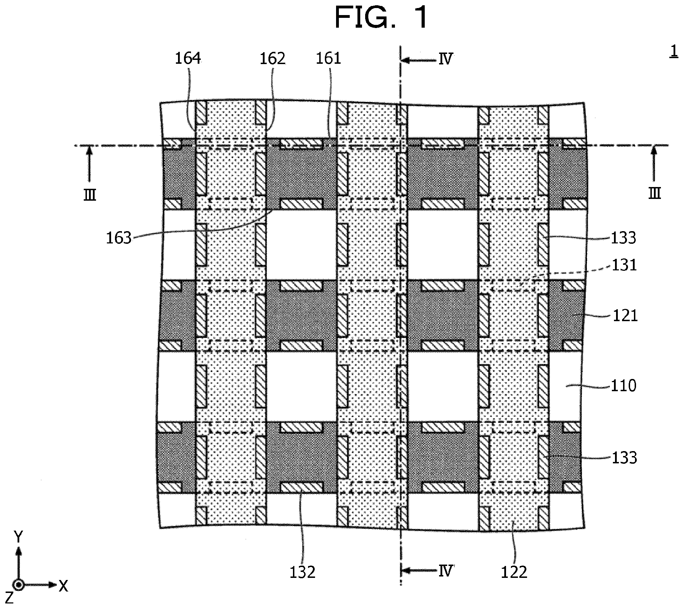

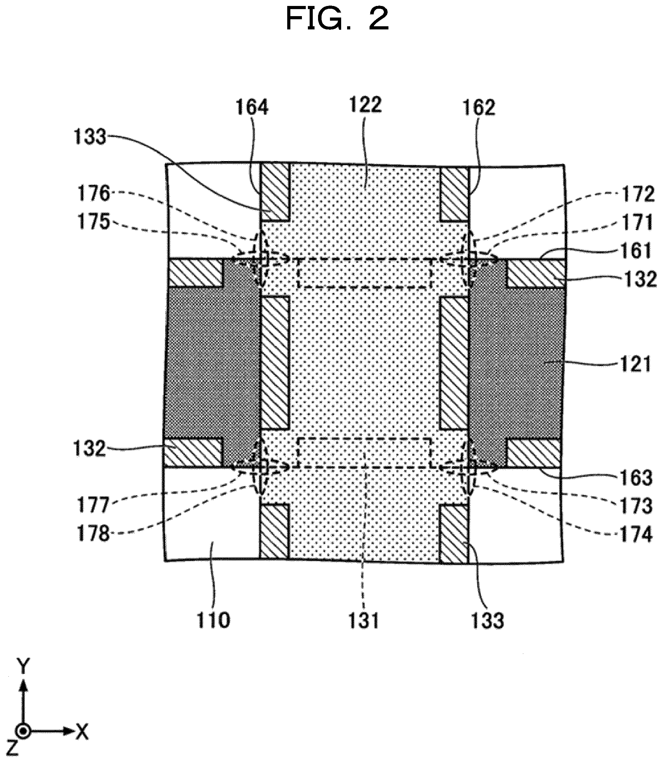

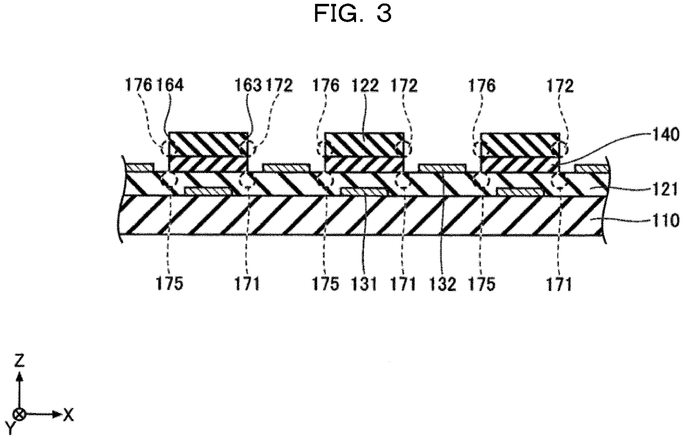

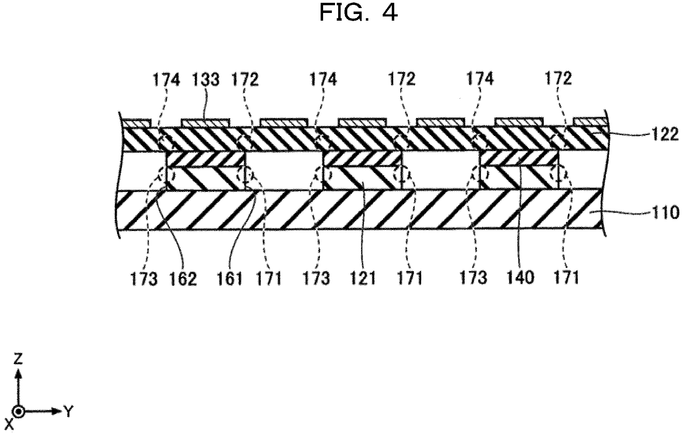

First, a first embodiment will be described. The first embodiment relates to a quantum bit circuit including a two-dimensional topological insulator. FIG. 1 is a top view of the quantum bit circuit according to the first embodiment. FIG. 2 is an enlarged view illustrating a part in FIG. 1. FIGs. 3 and 4 are cross-sectional diagrams illustrating the quantum bit circuit according to the first embodiment. FIG. 3 corresponds to a cross-sectional diagram taken along a line III-III in FIG. 1. FIG. 4 corresponds to a cross-sectional diagram taken along a line IV-IV in FIG. 1.

As illustrated in FIGs. 1 to 4, a quantum bit circuit 1 according to the first embodiment includes a substrate 110, a lower Majorana carrier 121 extending in an X-axis direction, and an upper Majorana carrier 122 extending in a Y-axis direction. The substrate 110 is, for example, an insulating substrate such as an alumina substrate or a sapphire substrate. The X-axis direction and the Y-axis direction are directions orthogonal to a Z-axis direction perpendicular to a surface of the substrate 110. The Y-axis direction intersects with the X-axis direction, and for example, the X-axis direction and the Y-axis direction are orthogonal to each other. In the present disclosure, to see an object from the Z-axis direction may be referred to as a plan view. The X-axis direction is an example of a first direction, and the Y-axis direction is an example of a second direction.

The lower Majorana carrier 121 is, for example, a two-dimensional topological insulator layer, and includes a first edge 161 and a third edge 163 extending in the X-axis direction. The first edge 161 is positioned on a - Y side of the third edge 163. The lower Majorana carrier 121 may be formed of a single two-dimensional topological insulator or may be formed by laminating a plurality of two-dimensional topological insulators. A material of the lower Majorana carrier 121 is, for example, tungsten ditelluride (WTe2). In the present embodiment, the plurality of lower Majorana carriers 121 is arranged side by side in the Y-axis direction. The lower Majorana carrier 121 is an example of a first Majorana carrier.

The upper Majorana carrier 122 is, for example, a two-dimensional topological insulator layer and includes a second edge 162 and a fourth edge 164 extending in the Y-axis direction. The second edge 162 is positioned on a - X side of the fourth edge 164. The upper Majorana carrier 122 may be formed of a single two-dimensional topological insulator or may be formed by laminating a plurality of two-dimensional topological insulators. A material of the upper Majorana carrier 122 is, for example, tungsten ditelluride (WTe2). In the present embodiment, the plurality of upper Majorana carriers 122 is arranged side by side in the X-axis direction. The upper Majorana carrier 122 is an example of a second Majorana carrier.

A lower s-wave superconductor layer 131 in contact with a lower surface of the lower Majorana carrier 121 is provided. The lower s-wave superconductor layer 131 is provided along the first edge 161 and the third edge 163, for each region overlapping the upper Majorana carrier 122 in plan view. An end of each lower s-wave superconductor layer 131 in the X-axis direction is separated from the second edge 162 and the fourth edge 164 of the upper Majorana carrier 122 in plan view. The lower s-wave superconductor layer 131 is, for example, an Al layer.

A lower s-wave superconductor layer 132 in contact with an upper surface of the lower Majorana carrier 121 is provided. The lower s-wave superconductor layer 132 is provided along the first edge 161 and the third edge 163, for each region between the upper Majorana carriers 122 adjacent to each other in plan view. An end of each lower s-wave superconductor layer 132 in the X-axis direction is separated from the second edge 162 and the fourth edge 164 of the upper Majorana carrier 122 in plan view. The lower s-wave superconductor layer 132 is, for example, an Al layer. The lower s-wave superconductor layers 131 and 132 are examples of a first s-wave superconductor layer.

An upper s-wave superconductor layer 133 in contact with an upper surface of the upper Majorana carrier 122 is provided. The upper s-wave superconductor layer 133 is provided along the second edge 162 and the fourth edge 164, for each region overlapping the lower Majorana carrier 121 and each region between lower Majorana carriers 121 adjacent to each other, in plan view. An end of the upper s-wave superconductor layer 133 in the X-axis direction is separated from the first edge 161 and the third edge 163 of the lower Majorana carrier 121 in plan view. The upper s-wave superconductor layer 133 is, for example, an Al layer. The upper s-wave superconductor layer 133 is an example of a second s-wave superconductor layer.

An etching stopper 140 is provided between the lower Majorana carrier 121 and the upper Majorana carrier 122. A material of the etching stopper 140 is, for example, graphene or graphite. In a case where the material of the etching stopper 140 is graphite, the thickness thereof is preferable as thin as possible, and is preferable to be equal to or less than five nm, for example. As described later, this is because Majorana particles tunnel through the etching stopper 140 between the lower Majorana carrier 121 and the upper Majorana carrier 122.

Wiring is individually coupled to the lower s-wave superconductor layer 131, the lower s-wave superconductor layer 132, and the upper s-wave superconductor layer 133.

In the quantum bit circuit 1, the Majorana particles can exist in a portion between the lower s-wave superconductor layer 131 and the lower s-wave superconductor layer 132 adjacent to each other at the first edge 161 in plan view and a portion between the lower s-wave superconductor layer 131 and the lower s-wave superconductor layer 132 adjacent to each other at the third edge 163 in plan view. Then, for example, in these portions where the Majorana particles can exist, a portion of the first edge 161 overlapping the second edge 162 functions as a first region 171, and a portion of the third edge 163 overlapping the second edge 162 functions as a third region 173. Furthermore, for example, in these portions where the Majorana particles can exist, a portion of the first edge 161 overlapping the fourth edge 164 functions as a fifth region 175, and a portion of the third edge 163 overlapping the fourth edge 164 functions as a seventh region 177.

Similarly, the Majorana particles can exist in a portion between the two upper s-wave superconductor layers 133 adjacent to each other at the second edge 162 in plan view and a portion between the two upper s-wave superconductor layers 133 adjacent to each other at the fourth edge 164 in plan view. Then, for example, in these portions where the Majorana particles can exist, a portion of the second edge 162 overlapping the first edge 161 functions as a second region 172, and a portion of the fourth edge 164 overlapping the first edge 161 functions as a sixth region 176. Furthermore, in these portions where the Majorana particles can exist, a portion of the second edge 162 overlapping the third edge 163 functions as a fourth region 174, and a portion of the fourth edge 164 overlapping the third edge 163 functions as an eighth region 178.

The Majorana particles existing in the first region 171 and the Majorana particles existing in the second region 172 can pass through the etching stopper 140 by a tunnel effect and interact with each other. Therefore, both Majorana particles can be regarded as the same Majorana particle. The same applies to a pair of the third region 173 and the fourth region 174, a pair of the fifth region 175 and the sixth region 176, and a pair of the seventh region 177 and the eighth region 178.

In this way, in the quantum bit circuit 1, the Majorana particles generated in the lower Majorana carrier 121 and the Majorana particles generated in the upper Majorana carrier 122 can easily interact with each other. Furthermore, as described later, such a structure can be manufactured with a high yield, with alignment accuracy of a typical semiconductor process.

Furthermore, by controlling states of the lower s-wave superconductor layers 131 and 132, the Majorana particles can be exchanged between the first region 171 and the fifth region 175 and between the third region 173 and the seventh region 177 adjacent to each other, with the lower s-wave superconductor layers 131 and 132 interposed therebetween. Similarly, by controlling a state of the upper s-wave superconductor layer 133, the Majorana particles can be exchanged between the second region 172 and the fourth region 174 and between the sixth region 176 and the eighth region 178 adjacent to each other, with the upper s-wave superconductor layer 133 interposed therebetween.

Moreover, in the quantum bit circuit 1, eight Majorana particles can be generated in a region where the lower Majorana carrier 121 and the upper Majorana carrier 122 overlap in plan view. Therefore, Majorana quantum bits can be accumulated at high density. Furthermore, the Majorana quantum bits can be regularly accumulated in a grid-like pattern, and wiring or the like can be easily designed.

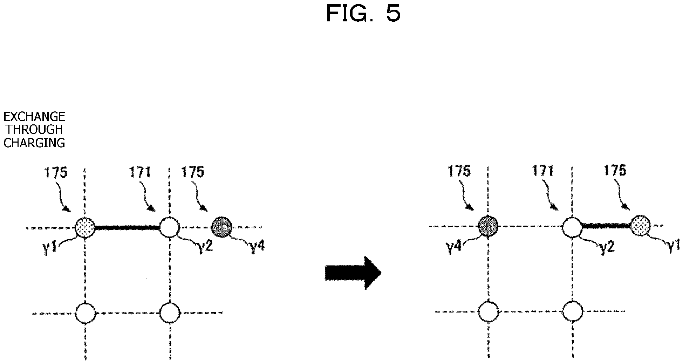

Here, an example of an operation of the quantum bit circuit 1 will be described. FIG. 5 is a diagram illustrating an example of the operation of the quantum bit circuit according to the first embodiment. Circles in FIG. 5 indicate Majorana particles in the regions 171 to 178. Furthermore, among line segments connecting two Majorana particles, a line segment indicated by a broken line indicates that an s-wave superconductor layer is in a state where the Majorana particles cannot be exchanged, and a line segment indicated by a solid line indicates that the s-wave superconductor layer is in a state where the Majorana particles can be exchanged.

In this example, the Majorana particles are exchanged between the two fifth regions 175 adjacent to each other with the first region 171 interposed therebetween in the X-axis direction. In other words, a Majorana particle γ1 generated in one fifth region 175 and a Majorana particle γ4 generated in another fifth region 175 are exchanged via a Majorana particle γ2 generated in the first region 171 between these fifth regions 175 through charging.

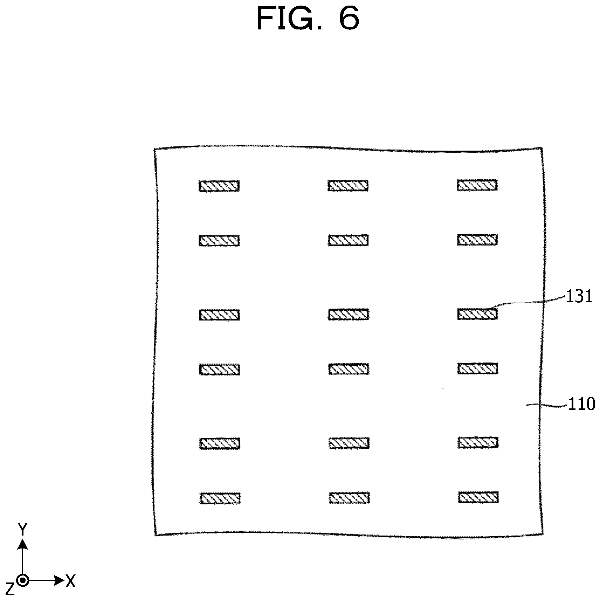

Next, a method for manufacturing the quantum bit circuit 1 according to the first embodiment will be described. FIGs. 6 to 13 are top views illustrating the method for manufacturing the quantum bit circuit according to the first embodiment.

First, as illustrated in FIG. 6, the lower s-wave superconductor layer 131 is formed on the substrate 110. The lower s-wave superconductor layer 131 can be formed by a deposition method, for example.

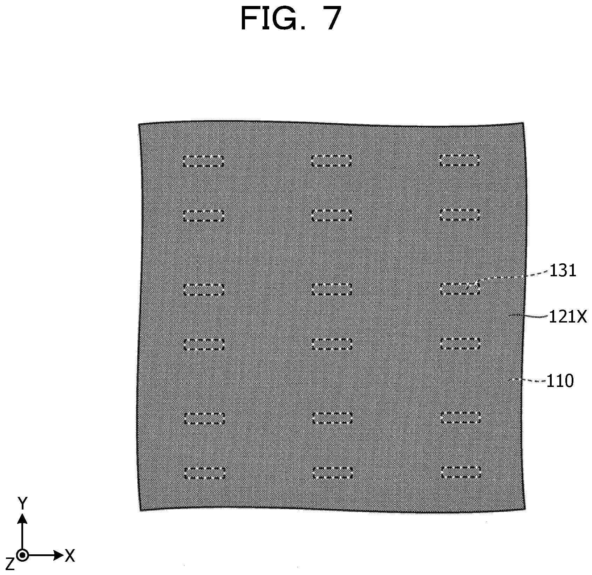

Next, as illustrated in FIG. 7, a two-dimensional topological insulator layer 121X is provided on the substrate 110 so as to cover the lower s-wave superconductor layer 131. The two-dimensional topological insulator layer 121X can be provided, for example, by separately growing the two-dimensional topological insulator layer 121X on a growth substrate (not illustrated) and transferring the two-dimensional topological insulator layer 121X from the growth substrate. The two-dimensional topological insulator layer 121X may be formed on the substrate 110.

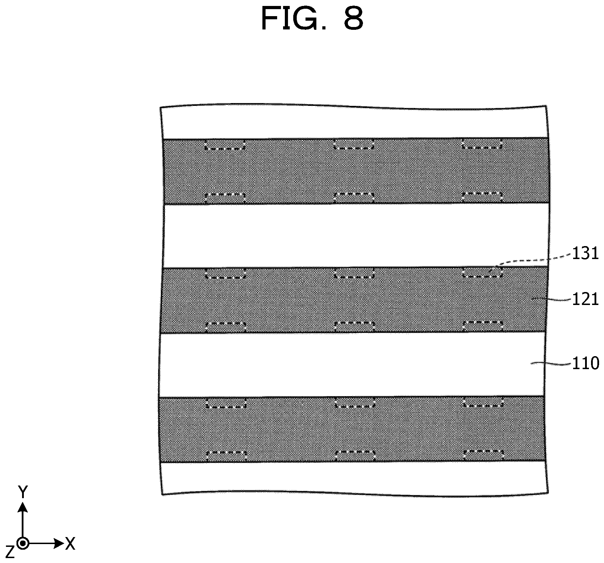

Thereafter, as illustrated in FIG. 8, the plurality of lower Majorana carriers 121 is formed by processing the two-dimensional topological insulator layer 121X. To process the two-dimensional topological insulator layer 121X, for example, reactive ion etching (RIE) is performed. As etching gas, for example, fluorocarbon gas is used.

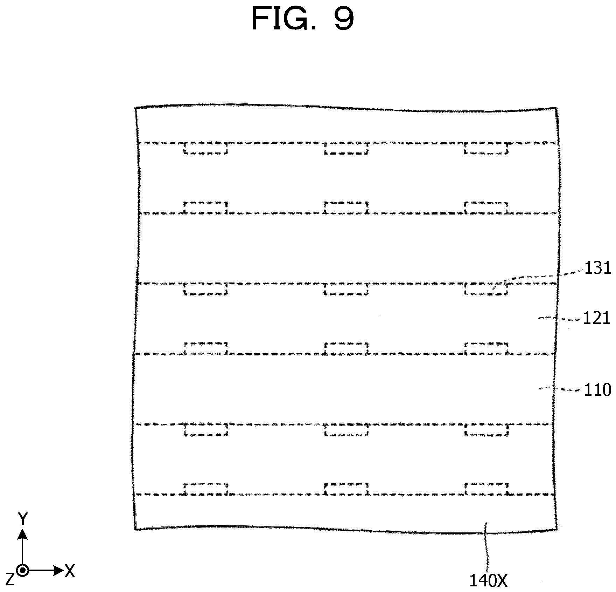

Subsequently, as illustrated in FIG. 9, an etching stopper 140X is provided above the substrate 110 so as to cover the lower Majorana carrier 121. The etching stopper 140X can be provided, for example, by separately growing the etching stopper 140X on a growth substrate (not illustrated) and transferring the etching stopper 140X from the growth substrate.

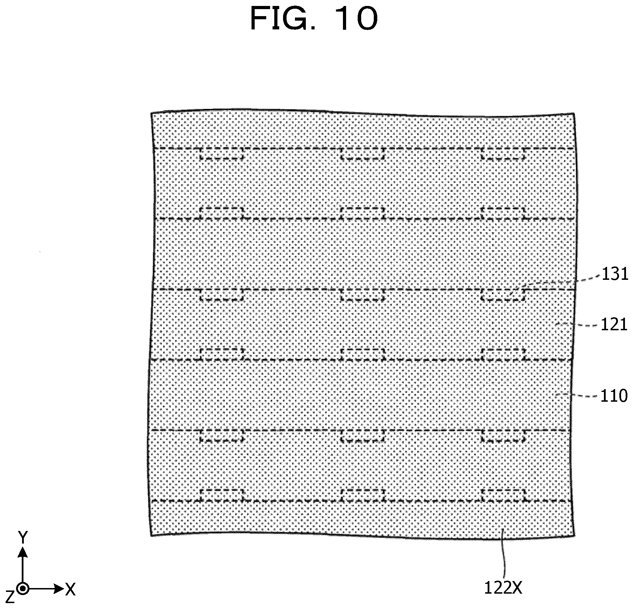

Next, as illustrated in FIG. 10, a two-dimensional topological insulator layer 122X is provided on the etching stopper 140X. The two-dimensional topological insulator layer 122X can be provided, for example, by separately growing the two-dimensional topological insulator layer 122X on a growth substrate (not illustrated) and transferring the two-dimensional topological insulator layer 122X from the growth substrate. The two-dimensional topological insulator layer 122X may be formed on the etching stopper 140X.

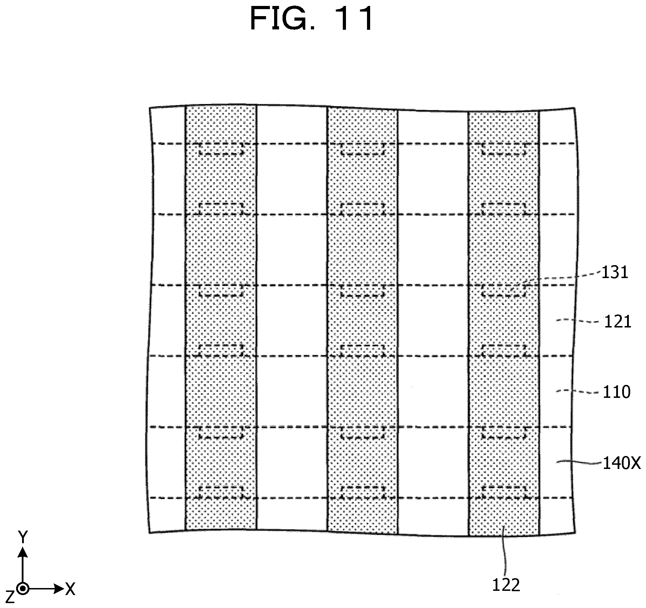

Thereafter, as illustrated in FIG. 11, the plurality of upper Majorana carriers 122 is formed by processing the two-dimensional topological insulator layer 122X. To process the two-dimensional topological insulator layer 122X, for example, the RIE is performed. As etching gas, for example, fluorocarbon gas is used. At this time, the lower Majorana carrier 121 is protected by the etching stopper 140X.

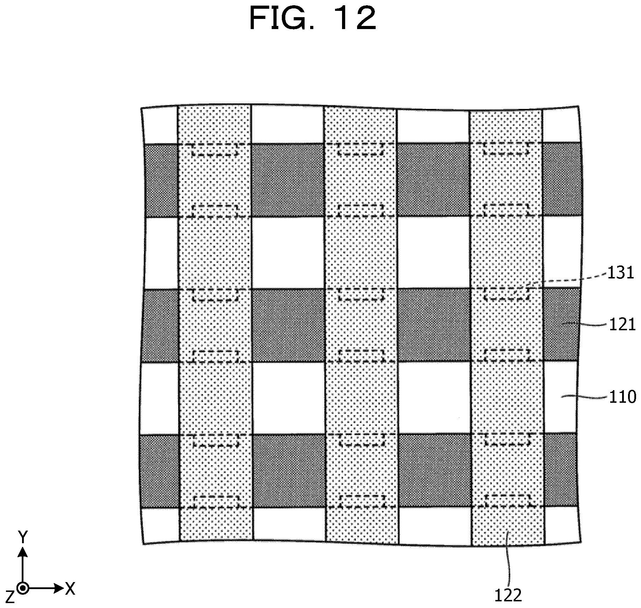

Subsequently, as illustrated in FIG. 12, by processing the etching stopper 140X, the etching stopper 140 is formed between the lower Majorana carrier 121 and the upper Majorana carrier 122. To process the etching stopper 140X, for example, the RIE is performed. As etching gas, for example, oxygen gas is used.

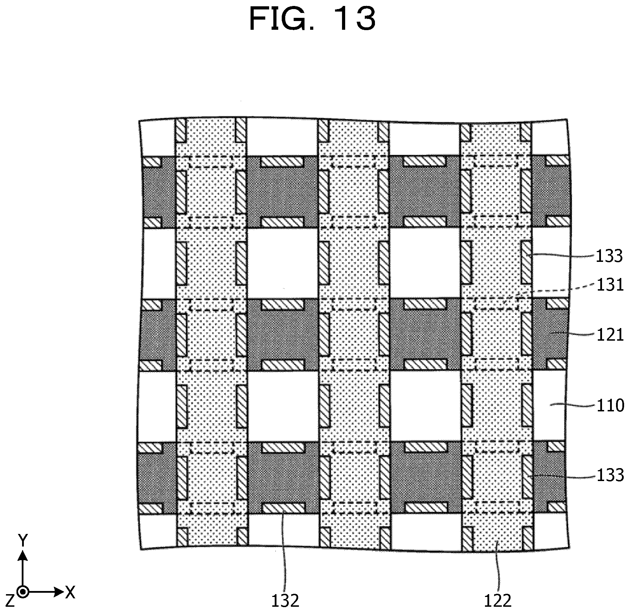

Next, as illustrated in FIG. 13, the lower s-wave superconductor layer 132 is formed on the lower Majorana carrier 121, and the upper s-wave superconductor layer 133 is formed on the upper Majorana carrier 122. The lower s-wave superconductor layer 132 and the upper s-wave superconductor layer 133 can be formed by the deposition method, for example.

Thereafter, wiring (not illustrated) or the like that is individually coupled to the lower s-wave superconductor layer 131, the lower s-wave superconductor layer 132, and the upper s-wave superconductor layer 133 is formed.

In this way, the quantum bit circuit 1 according to the first embodiment can be manufactured.

With such a method, with alignment accuracy of a typical semiconductor process, it is possible to manufacture the quantum bit circuit 1 with a high yield.

Note that both of the lower s-wave superconductor layer 131 and the lower s-wave superconductor layer 132 may have contact with the lower surface of the lower Majorana carrier 121, and both of the lower s-wave superconductor layer 131 and the lower s-wave superconductor layer 132 may have contact with the upper surface of the lower Majorana carrier 121.

### (Second Embodiment)

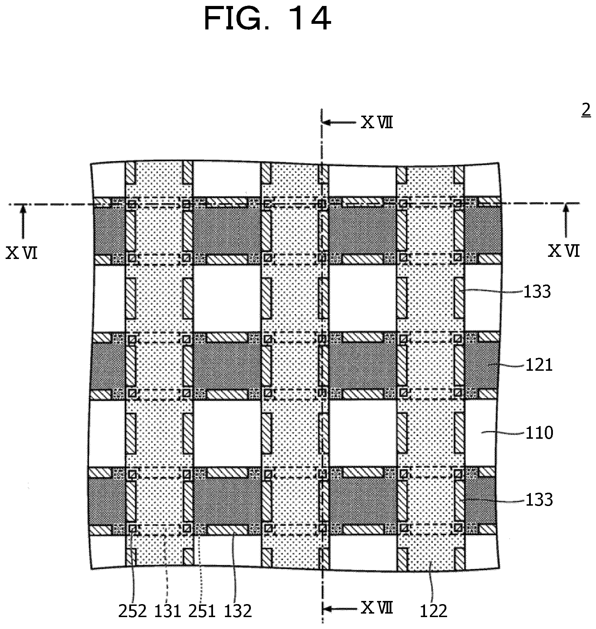

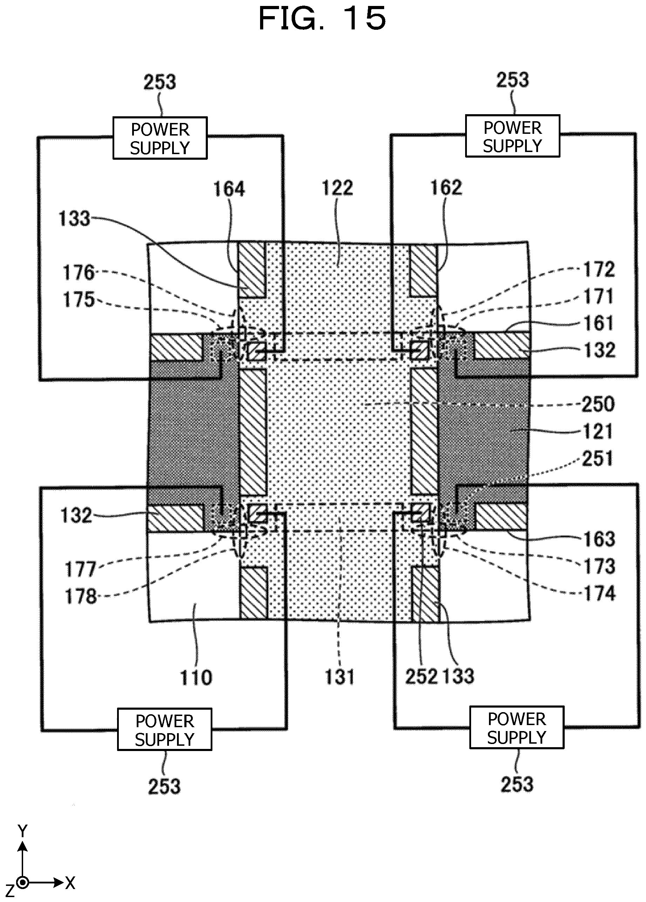

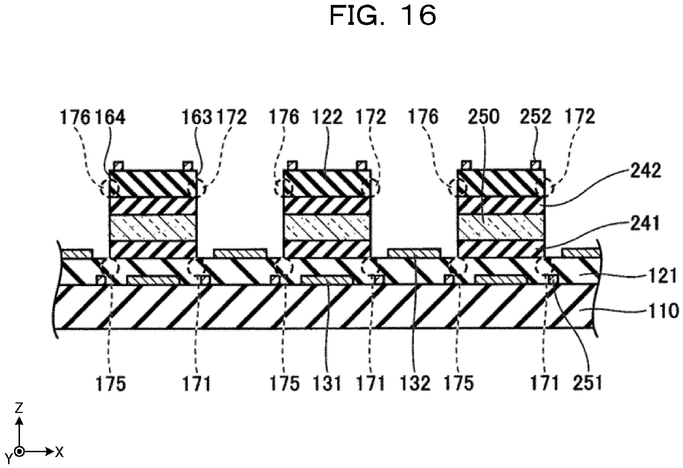

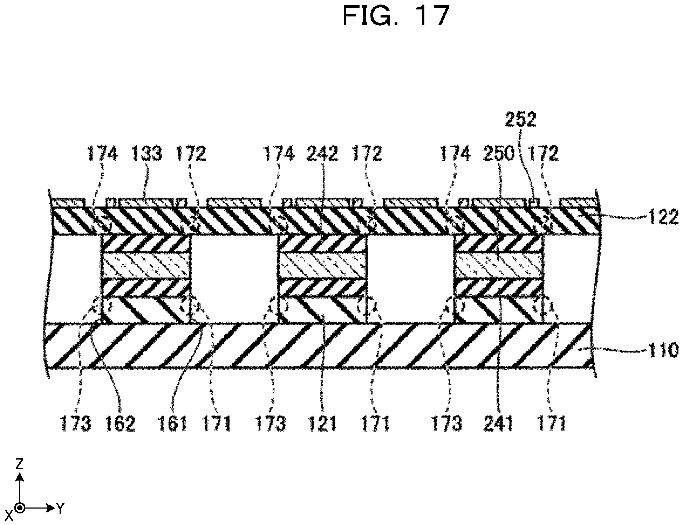

Next, a second embodiment will be described. The second embodiment is different from the first embodiment mainly in a configuration of a laminated structure including the lower Majorana carrier 121 and the upper Majorana carrier 122. FIG. 14 is a top view of a quantum bit circuit according to the second embodiment. FIG. 15 is an enlarged view illustrating a part in FIG. 14. FIGs. 16 and 17 are cross-sectional diagrams illustrating the quantum bit circuit according to the second embodiment. FIG. 16 corresponds to a cross-sectional diagram taken along a line XVI-XVI in FIG. 14. FIG. 17 corresponds to a cross-sectional diagram taken along a line XVII-XVII in FIG. 14.

As in the first embodiment, a quantum bit circuit 2 according to the second embodiment includes a substrate 110, a lower Majorana carrier 121, an upper Majorana carrier 122, a lower s-wave superconductor layer 131, a lower s-wave superconductor layer 132, and an upper s-wave superconductor layer 133. On the other hand, instead of the etching stopper 140, an etching stopper 241, an etching stopper 242, and a semiconductor layer 250 are provided between the lower Majorana carrier 121 and the upper Majorana carrier 122. The etching stopper 241 is provided between the lower Majorana carrier 121 and the semiconductor layer 250, and the etching stopper 242 is provided between the semiconductor layer 250 and the upper Majorana carrier 122.

A material of the etching stoppers 241 and 242 is, for example, graphene or graphite. In a case where the material of the etching stoppers 241 and 242 is graphite, the thickness thereof is preferable as thin as possible, and is preferable to be equal to or less than five nm, for example. This is because Majorana particles tunnel through the etching stoppers 241 and 242 between the lower Majorana carrier 121 and the upper Majorana carrier 122.

A material of the semiconductor layer 250 is, for example, a two-dimensional semiconductor such as tin diselenide (SnSe2). A conductivity type of the semiconductor layer 250 is not limited, and for example, may be an intrinsic semiconductor or an n-type semiconductor. The semiconductor layer 250 may be configured from a single two-dimensional semiconductor or may be configured by laminating a plurality of two-dimensional semiconductors. The semiconductor layer 250 is an example of a tunnel barrier layer.

A lower electrode 251 is provided between the lower s-wave superconductor layers 131 that are adjacent to each other in an X-axis direction. Similarly to the lower s-wave superconductor layer 131, the lower electrode 251 is covered with the lower Majorana carrier 121. For example, the lower electrode 251 is provided in a region that does not overlap the upper Majorana carrier 122 in plan view. The lower electrode 251 is provided, for example, in each of the vicinity of a first region 171, the vicinity of a third region 173, the vicinity of a fifth region 175, and the vicinity of a seventh region 177.

Furthermore, an upper electrode 252 is provided on the upper Majorana carrier 122. The upper electrode 252 is provided, for example, in each of the vicinity of a second region 172, the vicinity of a fourth region 174, the vicinity of a sixth region 176, and the vicinity of an eighth region 178.

As illustrated in FIG. 15, a power supply 253 is provided that applies a voltage between the lower electrode 251 and the upper electrode 252 respectively provided in the vicinity of the first region 171 and the vicinity of the second region 172 overlapping each other. Another power supply 253 is provided that applies a voltage between the lower electrode 251 and the upper electrode 252 respectively provided in the vicinity of the third region 173 and the vicinity of the fourth region 174 overlapping each other. Still another power supply 253 is provided that applies a voltage between the lower electrode 251 and the upper electrode 252 respectively provided in the vicinity of the fifth region 175 and the vicinity of the sixth region 176 overlapping each other. Yet another power supply 253 is provided that applies a voltage between the lower electrode 251 and the upper electrode 252 respectively provided in the vicinity of the seventh region 177 and the vicinity of the eighth region 178 overlapping each other.

Other components are similar to those of the first embodiment.

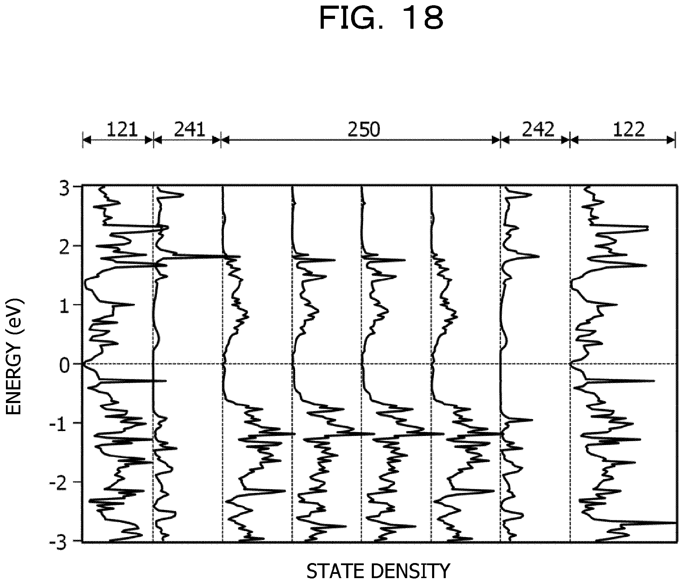

In the quantum bit circuit 2, a laminated film of the etching stopper 241, the semiconductor layer 250, and the etching stopper 242 exists between the lower Majorana carrier 121 and the upper Majorana carrier 122. Here, an example of a band diagram of a valence band and a conduction band of a laminate of the lower Majorana carrier 121, the etching stopper 241, the semiconductor layer 250, the etching stopper 242, and the upper Majorana carrier 122 is illustrated in FIG. 18. In the example illustrated in FIG. 18, each of the lower Majorana carrier 121 and the upper Majorana carrier 122 includes the same WTe2, and the etching stoppers 241 and 242 include graphene, and the semiconductor layer 250 includes four-layer SnSe2.

Because the semiconductor layer 250 is provided, a tunnel barrier exists between the Majorana particle generated in the lower Majorana carrier 121 and the Majorana particle generated in the upper Majorana carrier 122. A height of this tunnel barrier can be adjusted according to a magnitude of a gate voltage to be applied from the power supply 253. For example, by applying the gate voltage, it is possible to change a band of the semiconductor layer 250 and lower the tunnel barrier so as to induce a tunnel effect.

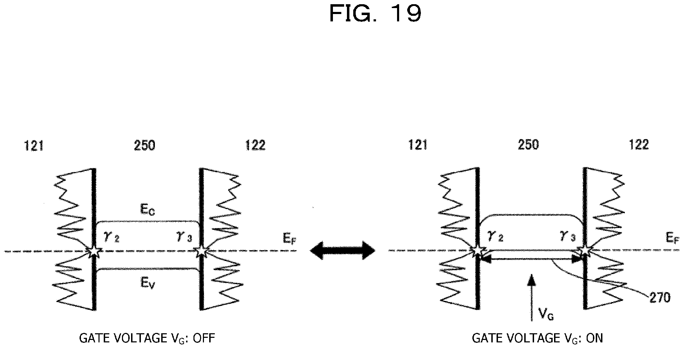

FIG. 19 is a diagram illustrating a change in a tunnel barrier. In FIG. 19, changes in a valence band EV and a conduction band EC of the semiconductor layer 250 are illustrated together with a Fermi level EF. By applying a gate voltage VG, a resonance tunnel effect can be realized. In this way, the Majorana particles can move between two states with the tunnel effect. Therefore, by restoring the tunnel barrier at a desired timing, for example, an exchange 270 between a Majorana particle γ2 generated in the first region 171 and a Majorana particle γ5 generated in the second region 172 can be performed. That is, a quantum gate operation can be performed.

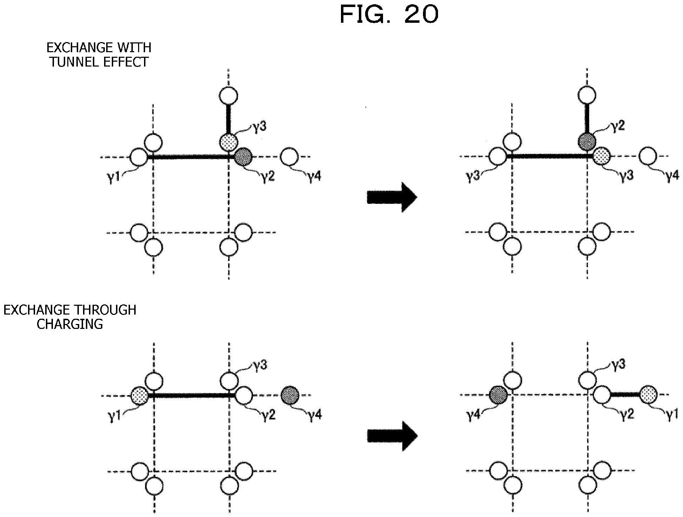

Here, an example of an operation of the quantum bit circuit 2 will be described. FIG. 20 is a diagram illustrating an example of the operation of the quantum bit circuit according to the second embodiment. As in FIG. 5, circles in FIG. 20 indicate Majorana particles in the regions 171 to 178. Furthermore, among line segments connecting two Majorana particles, a line segment indicated by a broken line indicates that an s-wave superconductor layer is in a state where the Majorana particles cannot be exchanged, and a line segment indicated by a solid line indicates that the s-wave superconductor layer is in a state where the Majorana particles can be exchanged.

In the quantum bit circuit 1 according to the first embodiment, the Majorana particle can be exchanged through charging. Whereas, in the quantum bit circuit 2 according to the second embodiment, the Majorana particles can be exchanged with the tunnel effect through control of the gate voltage, in addition to the exchange of the Majorana particles through charging.

In the exchange with the tunnel effect, as described above, by applying the gate voltage VG, the Majorana particles are exchanged between the first region 171 and the second region 172, for example. In other words, the Majorana particle γ2 generated in the first region 171 and the Majorana particle generated in the second region 172 are exchanged through a tunnel of the semiconductor layer 250.

Furthermore, in the exchange through charging, for example, the Majorana particles are exchanged between the two fifth regions 175 adjacent to each other with the first region 171 interposed therebetween in the X-axis direction. In other words, a Majorana particle γ1 generated in one fifth region 175 and a Majorana particle γ4 generated in another fifth region 175 are exchanged via a Majorana particle γ2 generated in the first region 171 between these fifth regions 175 through charging.

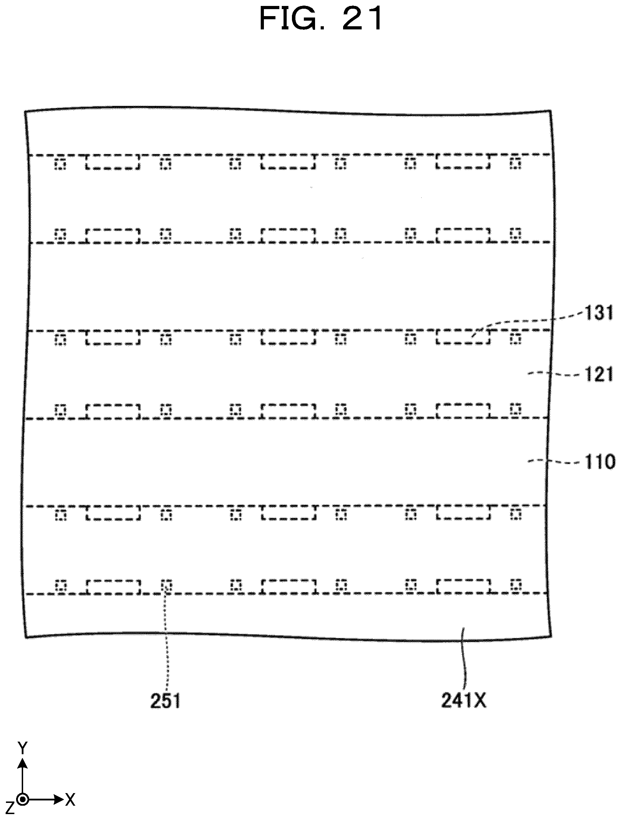

Next, a method for manufacturing the quantum bit circuit 2 according to the second embodiment will be described. FIGs. 21 to 29 are diagrams illustrating the method for manufacturing the quantum bit circuit according to the second embodiment.

First, as in the first embodiment, the lower s-wave superconductor layer 131 is formed on the substrate 110. The lower s-wave superconductor layer 131 can be formed by a deposition method, for example. Furthermore, the lower electrode 251 is formed on the substrate 110. The lower electrode 251 can be formed by the deposition method, for example. Next, as illustrated in FIG. 21, the plurality of lower Majorana carriers 121 is formed as in the first embodiment. Moreover, an etching stopper 241X is provided so as to cover the lower Majorana carrier 121, on the substrate 110. The etching stopper 241X can be provided, for example, by separately growing the etching stopper 241X on a growth substrate (not illustrated) and transferring the etching stopper 241X from the growth substrate. The etching stopper 241X is an example of a first etching stopper.

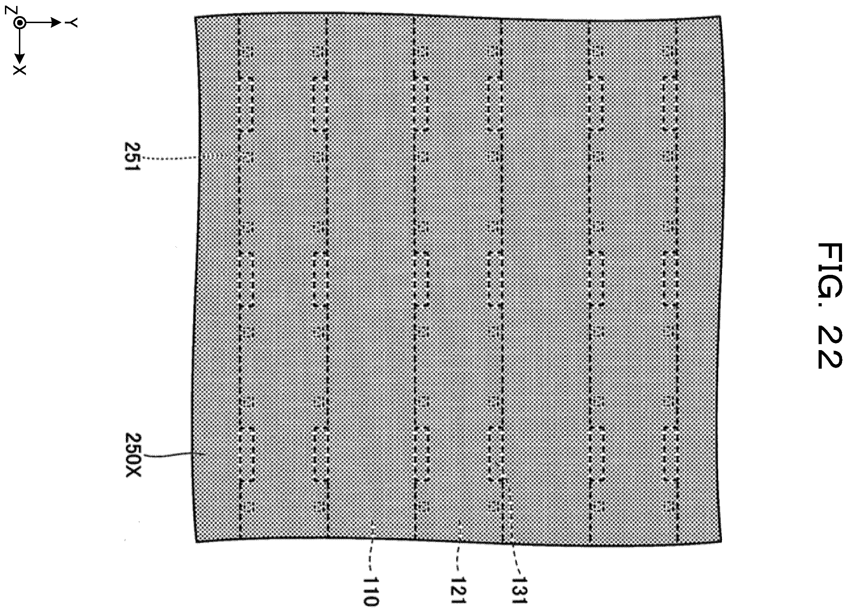

Thereafter, as illustrated in FIG. 22, a semiconductor layer 250X is provided on the etching stopper 241X. The semiconductor layer 250X can be provided, for example, by separately growing the semiconductor layer 250X on a growth substrate (not illustrated) and transferring the semiconductor layer 250X from the growth substrate.

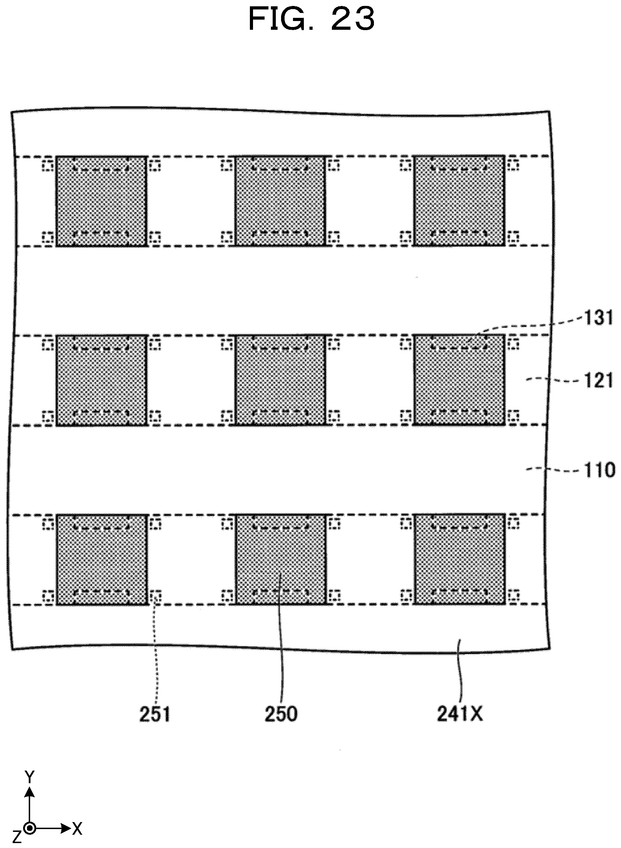

Subsequently, as illustrated in FIG. 23, by processing the semiconductor layer 250X, the plurality of semiconductor layers 250 is formed. To process the semiconductor layer 250X, for example, the RIE is performed. As etching gas, for example, fluorocarbon gas is used. At this time, the lower Majorana carrier 121 is protected by the etching stopper 241X.

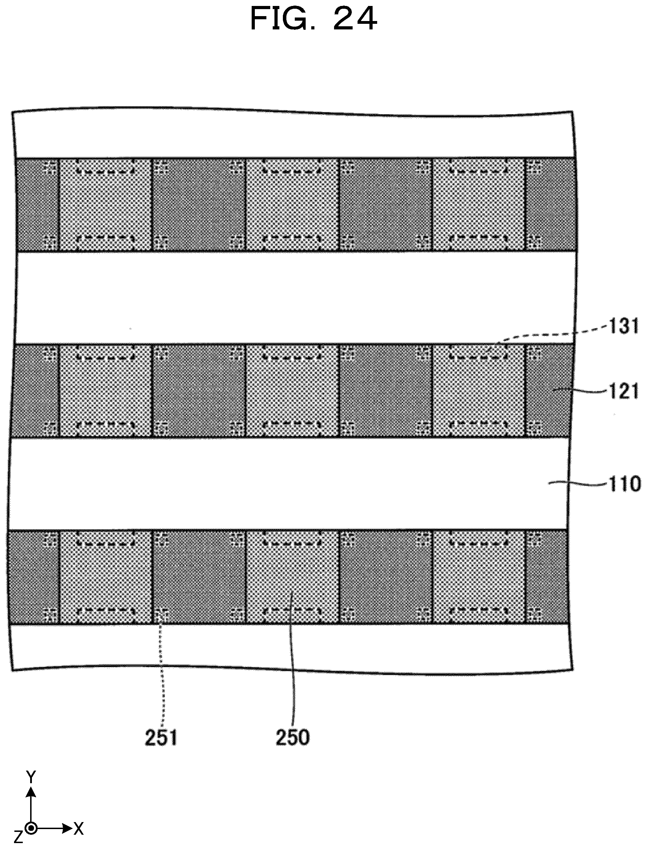

Next, as illustrated in FIG. 24, by processing the etching stopper 241X, the etching stopper 241 is formed between the lower Majorana carrier 121 and the semiconductor layer 250. To process the etching stopper 241X, for example, the RIE is performed. As etching gas, for example, oxygen gas is used.

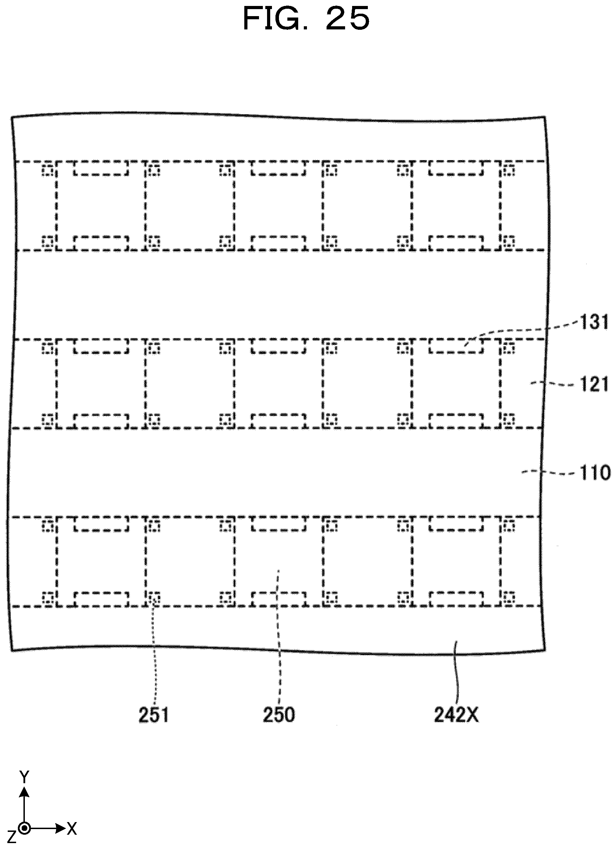

Thereafter, as illustrated in FIG. 25, an etching stopper 242X is provided so as to cover the lower Majorana carrier 121 and the semiconductor layer 250, above the substrate 110. The etching stopper 242X can be provided, for example, by separately growing the etching stopper 242X on a growth substrate (not illustrated) and transferring the etching stopper 242X from the growth substrate. The etching stopper 242X is an example of a second etching stopper.

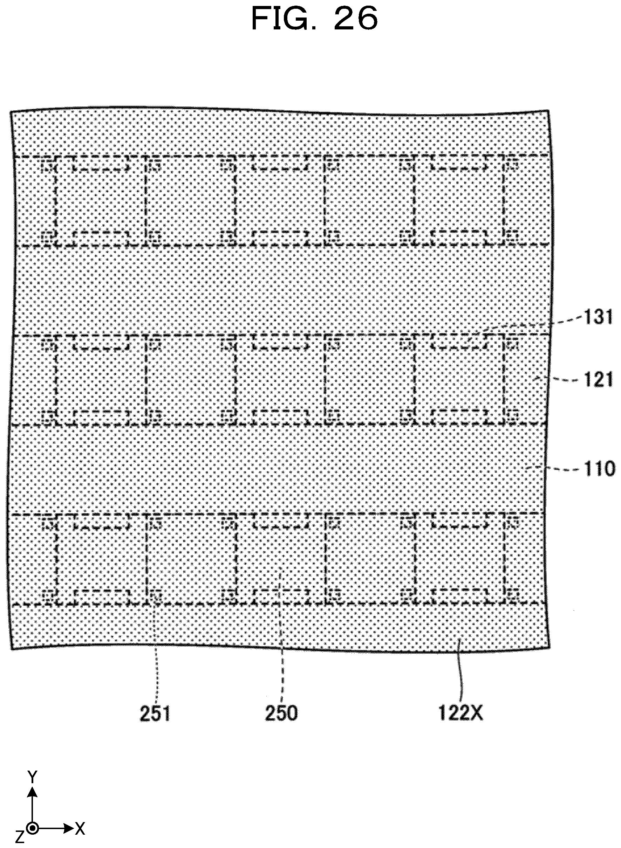

Subsequently, as illustrated in FIG. 26, a two-dimensional topological insulator layer 122X is provided on the etching stopper 242X. The two-dimensional topological insulator layer 122X can be provided, for example, by separately growing the two-dimensional topological insulator layer 122X on a growth substrate (not illustrated) and transferring the two-dimensional topological insulator layer 122X from the growth substrate. The two-dimensional topological insulator layer 122X may be formed on the etching stopper 242X.

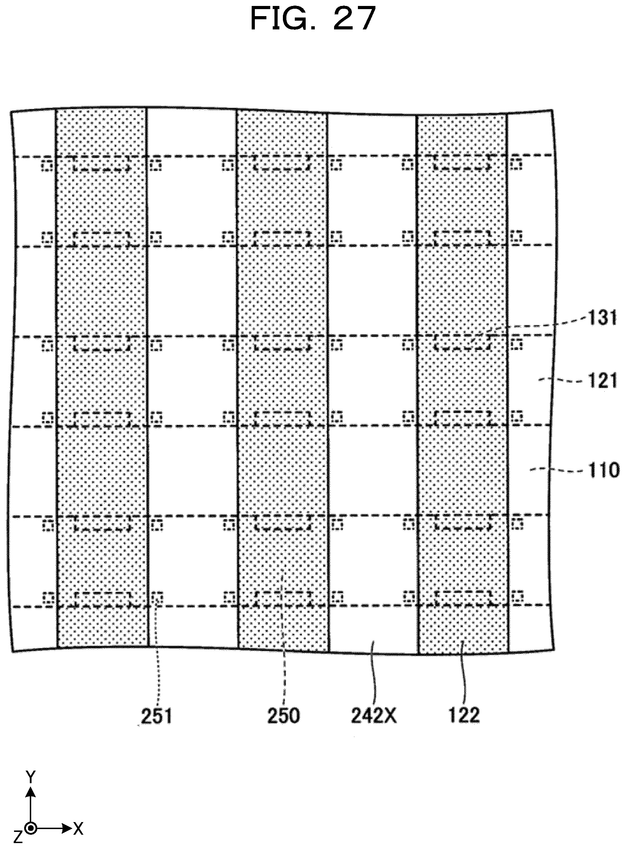

Next, as illustrated in FIG. 27, by processing the two-dimensional topological insulator layer 122X, the plurality of upper Majorana carriers 122 is formed. To process the two-dimensional topological insulator layer 122X, for example, the RIE is performed. As etching gas, for example, fluorocarbon gas is used. At this time, the lower Majorana carrier 121 is protected by the etching stopper 242X.

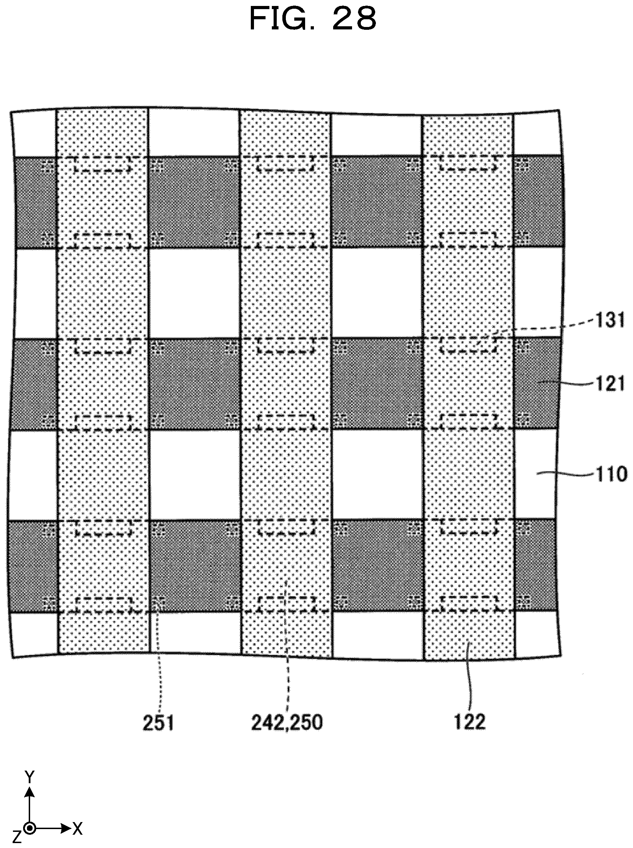

Thereafter, as illustrated in FIG. 28, by processing the etching stopper 242X, the etching stopper 242 is formed between the semiconductor layer 250 and the upper Majorana carrier 122. To process the etching stopper 242X, for example, the RIE is performed. As etching gas, for example, oxygen gas is used.

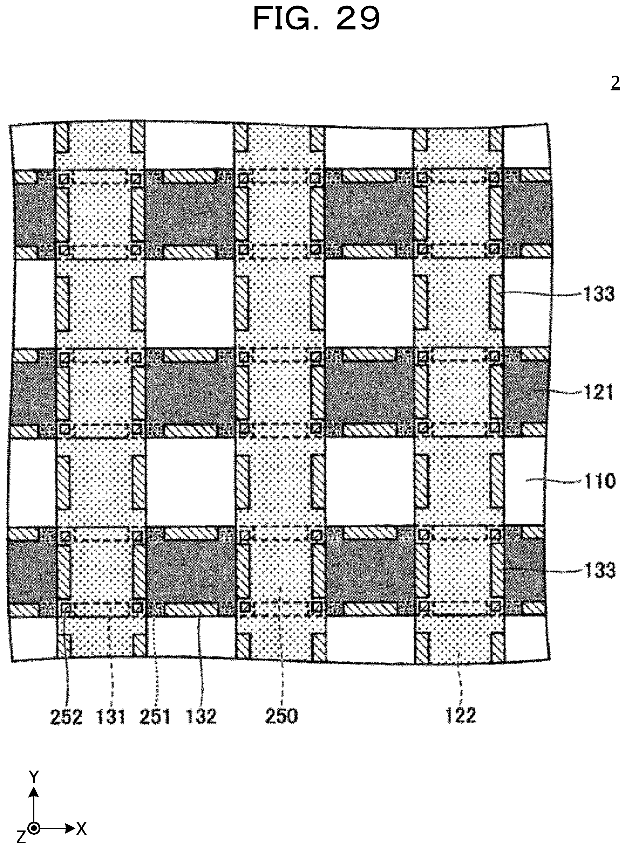

Subsequently, as illustrated in FIG. 29, the lower s-wave superconductor layer 132 is formed on the lower Majorana carrier 121, and the upper s-wave superconductor layer 133 is formed on the upper Majorana carrier 122. Moreover, the upper electrode 252 is formed on the upper Majorana carrier 122. The upper electrode 252 can be formed, for example, by the deposition method.

In this way, the quantum bit circuit 2 according to the second embodiment can be manufactured.

### (Third Embodiment)

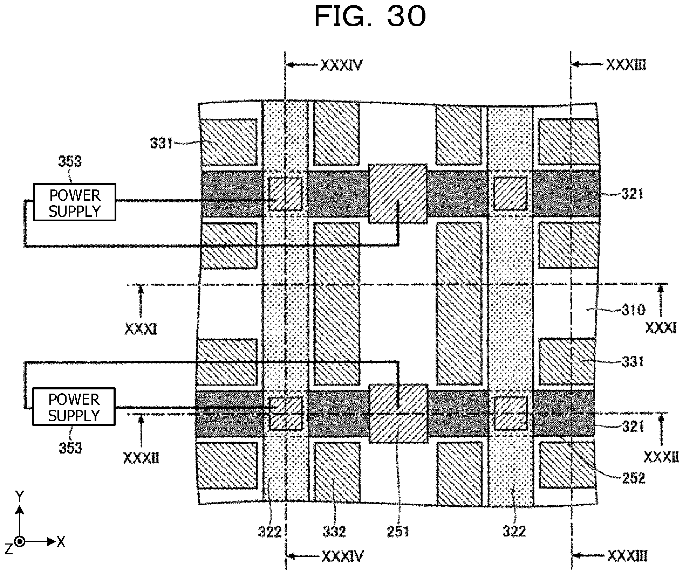

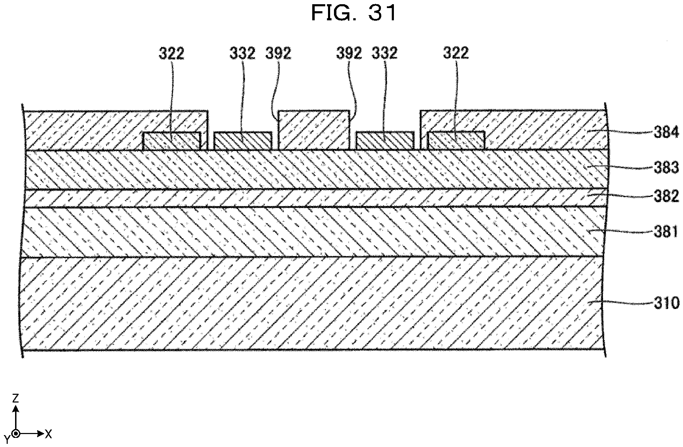

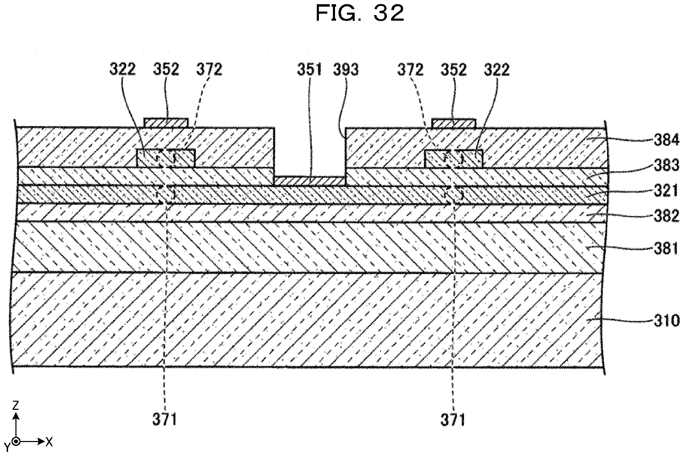

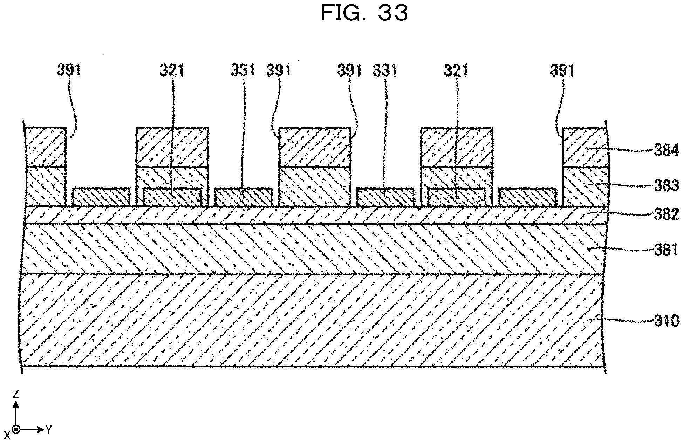

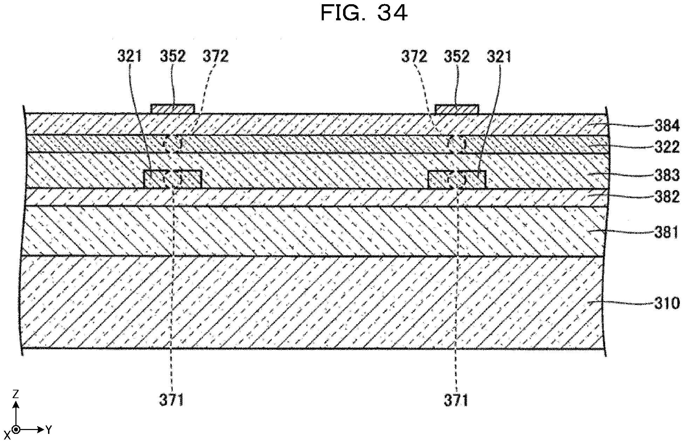

Next, a third embodiment will be described. The third embodiment relates to a quantum bit circuit including a semiconductor nanowire. FIG. 30 is a partially transparent top view illustrating the quantum bit circuit according to the third embodiment. FIGs. 31 to 34 are cross-sectional diagrams illustrating the quantum bit circuit according to the third embodiment. FIG. 31 corresponds to a cross-sectional diagram taken along a line XXXI-XXXI in FIG. 30. FIG. 32 corresponds to a cross-sectional diagram taken along a line XXXII-XXXII in FIG. 30. FIG. 33 corresponds to a cross-sectional diagram taken along a line XXXIII-XXXIII in FIG. 30. FIG. 34 corresponds to a cross-sectional diagram taken along a line XXXIV-XXXIV in FIG. 30.

As illustrated in FIGs. 30 to 34, a quantum bit circuit 3 according to the third embodiment includes a substrate 310, a lower Majorana carrier 321 extending in the X-axis direction, and an upper Majorana carrier 322 extending in the Y-axis direction. The substrate 310 is, for example, a semiconductor substrate such as a GaAs substrate or an InP substrate of which a plane direction of a surface is (100). The X-axis direction and the Y-axis direction are directions orthogonal to the Z-axis direction perpendicular to the surface of the substrate 310. The Y-axis direction intersects with the X-axis direction, and for example, the X-axis direction and the Y-axis direction are orthogonal to each other.

The lower Majorana carrier 321 is a semiconductor nanowire, for example, including InAs. In the present embodiment, the plurality of lower Majorana carriers 321 is arranged side by side in the Y-axis direction. The lower Majorana carrier 321 is an example of a first Majorana carrier.

The upper Majorana carrier 322 is a semiconductor nanowire, for example, including InAs. In the present embodiment, the plurality of upper Majorana carriers 122 is arranged side by side in the X-axis direction. The upper Majorana carrier 322 is an example of a second Majorana carrier.

A buffer layer 381 and an underlying semiconductor layer 382 are provided on the substrate 310. For example, the buffer layer 381 is an In1 - xAlxAs layer of which the thickness is about one µm, and an Al composition x may change so as to be lattice-matched with the substrate 310 and the underlying semiconductor layer 382, from an interface with the substrate 310 to an interface with the underlying semiconductor layer 382. For example, the underlying semiconductor layer 382 is an In0.81Ga0.19As layer of which the thickness is about four nm.

The lower Majorana carrier 321 is formed on the underlying semiconductor layer 382. The thickness of the lower Majorana carrier 321 is, for example, about five nm. A barrier layer 383 is formed on the underlying semiconductor layer 382 so as to cover the lower Majorana carrier 321. For example, the barrier layer 383 is an In0.9Al0.1As layer of which the thickness is about five nm, on the lower Majorana carrier 321. The lower Majorana carrier 321 is covered with the barrier layer 383 and functions as a quantum well.

The upper Majorana carrier 322 is formed on the barrier layer 383. The thickness of the upper Majorana carrier 322 is, for example, about five nm. A barrier layer 384 is formed on the barrier layer 383 so as to cover the upper Majorana carrier 322. For example, the barrier layer 384 is an In0.9Al0.1As layer of which the thickness is about five nm on the upper Majorana carrier 322. The upper Majorana carrier 322 is covered with the barrier layer 384 and functions as a quantum well.

As illustrated in FIGs. 30 and 33, an opening portion 391 reaching the underlying semiconductor layer 382 is formed in the barrier layers 383 and 384, in the vicinity of the lower Majorana carrier 321 in plan view, and a lower s-wave superconductor layer 331 is provided in the opening portion 391. The lower s-wave superconductor layer 331 is, for example, an Al layer. The lower s-wave superconductor layer 331 is an example of a first s-wave superconductor layer.

As illustrated in FIGs. 30 and 31, an opening portion 392 reaching the barrier layer 383 is formed in the barrier layer 384, in the vicinity of the upper Majorana carrier 322 in plan view, and an upper s-wave superconductor layer 332 is provided in the opening portion 392. The upper s-wave superconductor layer 332 is, for example, an Al layer. The upper s-wave superconductor layer 332 is an example of a second s-wave superconductor layer.

As illustrated in FIGs. 30 and 32, an opening portion 393 reaching the lower Majorana carrier 321 is formed in the barrier layers 383 and 384, and a lower electrode 351 is formed in the opening portion 393. As illustrated in FIGs. 30, 32, and 34, an upper electrode 352 is formed on the barrier layer 384 in a region where the lower Majorana carrier 321 and the upper Majorana carrier 322 overlap in plan view. A power supply 353 is provided that applies a voltage between the single lower electrode 351 and the single upper electrode 352 adjacent to each other in the X-axis direction. The power supply 353 is provided for each pair of the lower electrode 351 and the upper electrode 352.

In the quantum bit circuit 3, the Majorana particles can exist in a portion of the lower Majorana carrier 321 overlapping the upper Majorana carrier 322 in plan view and a portion of the upper Majorana carrier 322 overlapping the lower Majorana carrier 321 in plan view. Then, for example, in these portions where the Majorana particles can exist, the portion of the lower Majorana carrier 321 overlapping the upper Majorana carrier 322 in plan view functions as a first region 371, and the portion of the upper Majorana carrier 322 overlapping the lower Majorana carrier 321 in plan view functions as a second region 372.

Furthermore, by controlling a state of the lower s-wave superconductor layer 331, the Majorana particles can be exchanged between the two first regions 371 adjacent to each other in the X-axis direction. Similarly, by controlling a state of the upper s-wave superconductor layer 332, the Majorana particles can be exchanged between the two second regions 372 adjacent to each other in the Y-axis direction. Moreover, by adjusting the gate voltage to be applied from the power supply 353, the Majorana particles can be exchanged between the first region 371 and the second region 372 adjacent to each other in the Z-axis direction.

Note that a graphene nanoribbon can be used as a Majorana carrier.

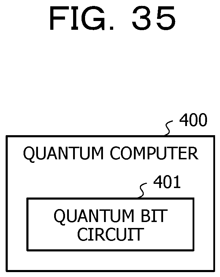

As illustrated in FIG. 35, the quantum bit circuits 1 to 3 according to these embodiments can be incorporated in a quantum computer 400 and used, for example, as a quantum bit circuit 401.

Although the preferred embodiments and the like have been described in detail above, the present disclosure is not limited to the embodiments and the like described above, and various modifications and substitutions may be made to the embodiments and the like described above without departing from the scope described in claims.

### CITATION LIST

### PATENT DOCUMENT

Patent Document 1: Japanese Laid-open Patent Publication No. 2013-247267
Patent Document 2: Japanese National Publication of International Patent Application No. 2020-511780

### NON-PATENT DOCUMENT

Non-Patent Document 1: Coulomb-assisted braiding of Majorana fermions in a Josephson junction array, New Journal of Physics 14, 035019 (2012)
Non-Patent Document 2: Minimal circuit for a flux-controlled Majorana qubit in a quantum spin-Hall insulator, Physica Scripta T164, 014007 (2015)
Non-Patent Document 3: Direct visualization of a two-dimensional topological insulator in the single-layer 1T'-WTe2, Physical Review B 96, (2017)

### REFERENCE SIGNS LIST

1, 2, 3, 401 quantum bit circuit
110 substrate
121, 321 lower Majorana carrier
122, 322 upper Majorana carrier
131, 132, 331 lower s-wave superconductor layer
133, 332 upper s-wave superconductor layer
140, 241, 242 etching stopper
161 to 164 edge
171 to 178, 371, 372 region
250 semiconductor layer
251, 351 lower electrode
252, 352 upper electrode
253, 353 power supply
400 quantum computer

## Claims

1. A quantum bit circuit comprising:
a first Majorana carrier that includes a first edge and extends in a first direction; and
a second Majorana carrier that includes a second edge and extends in a second direction that intersects with the first direction, wherein
the first Majorana carrier includes a first region where a Majorana particle is able to exist, in a portion of the first edge that overlaps the second edge in plan view,
the second Majorana carrier includes a second region where a Majorana particle is able to exist, in a portion of the second edge that overlaps the first edge in plan view, and
the Majorana particle in the first region and the Majorana particle in the second region are exchangeable.

2. The quantum bit circuit according to claim 1, wherein
the first Majorana carrier includes a first topological insulator layer, and
the second Majorana carrier includes a second topological insulator layer.

3. The quantum bit circuit according to claim 2, wherein the first topological insulator layer and the second topological insulator layer are WTe2 layers.

4. The quantum bit circuit according to any one of claims 1 to 3, further comprising: an etching stopper provided between the first Majorana carrier and the second Majorana carrier and through which the Majorana particle in the first region and the Majorana particle in the second region are able to tunnel.

5. The quantum bit circuit according to any one of claims 1 to 4, further comprising:
a first s-wave superconductor layer that has contact with the first Majorana carrier and is provided as sandwiching the first region in the first direction; and
a second s-wave superconductor layer that has contact with the second Majorana carrier and is provided as sandwiching the second region in the second direction.

6. The quantum bit circuit according to any one of claims 1 to 5, further comprising: a tunnel barrier layer provided between the first Majorana carrier and the second Majorana carrier.

7. The quantum bit circuit according to claim 6, wherein the tunnel barrier layer is a SnSe2 layer.

8. The quantum bit circuit according to claims 6 or 7, further comprising: a power supply configured to apply a voltage between the first Majorana carrier and the second Majorana carrier.

9. The quantum bit circuit according to any one of claims 1 to 8, wherein
the first Majorana carrier includes a third edge that extends in the first direction,
the first Majorana carrier includes a third region where the Majorana particle is able to exist, in a portion of the third edge that overlaps the second edge in plan view,
the second Majorana carrier includes a fourth region where the Majorana particle is able to exist, in a portion of the second edge that overlaps the third edge in plan view, and
the Majorana particle in the third region and the Majorana particle in the fourth region are exchangeable, and
the Majorana particle in the first region and the Majorana particle in the third region are exchangeable.

10. The quantum bit circuit according to claim 9, wherein
the second Majorana carrier includes a fourth edge that extends in the second direction,
the first Majorana carrier includes
a fifth region where the Majorana particle is able to exist, in a portion of the first edge that overlaps the fourth edge in plan view and
a seventh region where the Majorana particle is able to exist, in a portion of the third edge that overlaps the fourth edge in plan view,
the second Majorana carrier includes
a sixth region where the Majorana particle is able to exist, in a portion of the fourth edge that overlaps the first edge in plan view and
an eighth region where the Majorana particle is able to exist, in a portion of the fourth edge that overlaps the third edge in plan view,
the Majorana particle in the fifth region and the Majorana particle in the sixth region are exchangeable,
the Majorana particle in the seventh region and the Majorana particle in the eighth region are exchangeable,
the Majorana particle in the fifth region and the Majorana particle in the seventh region are exchangeable,
the Majorana particle in the second region and the Majorana particle in the sixth region are exchangeable, and
the Majorana particle in the fourth region and the Majorana particle in the eighth region are exchangeable.

11. A quantum bit circuit comprising:
a first Majorana carrier configured to extend in a first direction; and
a second Majorana carrier configured to extend in a second direction that intersects with the first direction, wherein
the First Majorana carrier includes a first region where a Majorana particle is able to exist, in a portion that overlaps the second Majorana carrier in plan view,
the second Majorana carrier includes a second region where a Majorana particle is able to exist, in a portion that overlaps the first Majorana carrier in plan view, and
the Majorana particle in the first region and the Majorana particle in the second region are exchangeable.

12. The quantum bit circuit according to claim 11, wherein
the first Majorana carrier includes a first semiconductor nanowire, and
the second Majorana carrier includes a second semiconductor nanowire.

13. The quantum bit circuit according to claim 11 or 12, further comprising:
a first s-wave superconductor layer provided on a side of the first Majorana carrier, as sandwiching the first region in the first direction; and
a second s-wave superconductor layer provided on a side of the second Majorana carrier, as sandwiching the second region in the second direction.

14. A quantum computer comprising a quantum bit circuit according to any one of claims 1 to 13.

15. A method for manufacturing a quantum bit circuit, the method comprising:
a process of forming a first Majorana carrier that includes a first edge and extends in a first direction; and
a process of forming a second Majorana carrier that includes a second edge and extends in a second direction that intersects with the first direction, wherein
the first Majorana carrier includes a first region where a Majorana particle is able to exist, in a portion of the first edge that overlaps the second edge in plan view,
the second Majorana carrier includes a second region where a Majorana particle is able to exist, in a portion of the second edge that overlaps the first edge in plan view, and
the Majorana particle in the first region and the Majorana particle in the second region are exchangeable.

16. The method for manufacturing the quantum bit circuit according to claim 15, further comprising:
between the process of forming the first Majorana carrier and the process of forming the second Majorana carrier,
a process of providing an etching stopper that covers the first Majorana carrier; and
a process of providing a two-dimensional topological insulator layer on the etching stopper, wherein
the process of forming the second Majorana carrier includes a process of etching the two-dimensional topological insulator layer while protecting the first Majorana carrier with the etching stopper.

17. The method for manufacturing the quantum bit circuit according to claim 15, further comprising:
between the process of forming the first Majorana carrier and the process of forming the second Majorana carrier,
a process of providing a first etching stopper that covers the first Majorana carrier;
a process of providing a semiconductor layer on the first etching stopper;
a process of forming a tunnel barrier layer positioned between the first Majorana carrier and the second Majorana carrier, by etching the semiconductor layer while protecting the first Majorana carrier with the first etching stopper;
a process of providing a second etching stopper that covers the tunnel barrier layer; and
a process of providing a two-dimensional topological insulator layer, on the second etching stopper, wherein
the process of forming the second Majorana carrier includes a process of etching the two-dimensional topological insulator layer while protecting the first Majorana carrier with the second etching stopper.
